# EUROPEAN PATENT SPECIFICATION

(11) **EP 2 204 474 B1**
(45) Date of publication and mention of the grant of the patent: **01.08.2012**
(21) Application number: 09011927.2
(22) Date of filing: 18.09.2009
(51) Int. Cl.: C25D 1/04, C30B 7/12, C30B 29/46, C30B 29/60

(54) **Method for fabricating Ge-Sb-Te nanowires**
Verfahren zur Herstellung von Ge-Sb-Te Nanodrähten
Procédé de fabrication de nano-fils de Ge-Sb-Te

(30) Priority: 31.12.2008 KR 20080137859
(43) Date of publication of application: 07.07.2010
(73) Proprietor: Korea University Research and Business Foundation, Seoul 136-713 (KR)
(72) Inventor: Kim, Young Keun, Gangnam-gu, Seoul, 135-906 (KR); Ji, Hye Min, Yeongtong-gu, Suwon-si, Gyeonggi-do, 443-737 (KR); An, Boo Hyun, Deokyang-gu, Goyang-si, Gyeonggi-do, 412-510 (KR); Cho, Moon Kyu, Mapo-gu, Seoul, 121-190 (KR); Min, Ji Hyun, Gwanak-gu, Seoul, 151-767 (KR)
(74) Representative: Samson & Partner

(56) References cited:
- EP-A- 1 925 696
- US-A1- 2008 156 654
- CHEN ET AL: "Silver selenide nanowires by electrodeposition" J. ELECTROCHEMICAL SOCIETY, vol. 150, no. 3, 28 January 2003 (2003-01-28), pages G183-G186, XP002562979 USA
- CHUANGUI JIN ET AL: "Large-area Sb2Te3 nanowire arrays" J.PHYS.CHEM B, vol. 109, no. 4, 2005, pages 1430-1432, XP002562980
- VENKATASAMY ET AL.: "ALD approach toward electrodeposition of Sb2Te3 for phase-change memory applications" J.ELECTROCHEM. SOC., vol. 155, no. 11, 5 November 2008 (2008-11-05), pages D693-D698, XP002562981 USA
- LEE ET AL: "Highly scalable non volatile and ultra low power phase change nanowire memory", NATURE NANOTECNOLOGY, vol. 2, 1 October 2007 (2007-10-01), pages 626-630,

## Description

### Field of the Invention

The present invention relates to a method for fabricating multi-component nanowires. Particularly, the present invention relates to a method for fabricating Ge-Sb-Te nanowires. Especially, the present invention relates to a method for fabricating multi-component nanowires used to implement a nanowire-based memory device by an electroplating process using a multi-component solution.

### Background of the Invention

A phase change random access memory (PRAM) or a resistive random access memory (ReRAM), which is one of non-volatile memories, is attracting attention as a leading next generation memory device which can replace a dynamic random access memory (DRAM), which is a main stream memory at present, owing to the advantages such as high storage speed and density, non-volatility, small size, low power consumption and low production cost, and so on, and thus many studies have been conducted on the PRAM and the ReRAM.

The PRAM basically operates based on a different principle from that of a general semiconductor memory, and writes data using a phenomenon that the crystalline state of phase change materials based on chalcogenide compounds is changed by electrical switching.

To realize a memory device of a very small size, nanowires have been suggested as an alternative for a thin film as a memory layer in the PRAM.

Conventional nanowire fabrication methods include a vapor-liquid-solid (VLS) process (that is, an epitaxial process), a chemical vapor deposition (CVD) process, and a physical vapor deposition (PVD) process.

However, these conventional methods have a problem that the fabrication cost is high because the price of equipment used to fabricate nanowires is high or the process takes a long time and is complicated. That is, the conventional methods have been carried out usually by sputtering, E-beam evaporation or plasma enhanced chemical vapor deposition (PECVD), but have a problem that the fabrication cost is high and the fabrication process is complicated because high-priced equipment is used and the fabrication is performed in high temperature and vacuum.

EP 1 925 696 A2 discloses an iron-gold barcode nanowire and a manufacturing method thereof. The document shows a nanotemplate which is disposed in an electrolytic solution including a first precursor for generating an iron ion and a second precursor for generating a gold ion. An electro-deposition is performed to alternately and repeatedly form an ion layer and a gold layer in a pore.

US 2008/0156654 A1 discloses a method for providing a nanostructure identification tag. Alumina membranes with 200 nm pore diameters and annular support rings were used as templates in experiments. Prior to the electroplating, a 0.5 -1.0 µm thick silver layer was thermally evaporated and deposited on one surface of the membrane to provide electrical contact for further electrodeposition.

Chen et al.: "Silver Selenide Nanowires by Electrodeposition", J. Electrochemical Society, Vol. 150, No. 3, 28 January 2003, pages G183-G186 disclose a method of synthesizing silver selenide nanowires by potentiostatic electrodeposition into anodic alumina membranes from an aqueous acid electrolyte containing silver ion complexed with SCN⁻and selenium dioxide at room temperature.

Chuangui Jin et al.: "Large-Area Sb2Te3 Nanowire Arrays", J. Phys. Chem. B., Vol. 109, No. 4, 2005, pages 1430 - 1432 disclose high -density large-area nanowire arrays of thermoelectric material Sb₂Te₃ that have been prepared using electrochemical deposition into channels of a porous anondic membrane.

Venkatasamy et al.: " ALD Approach toward Electrodeposition of Sb2Te3 for Phase-Change Memory Applications", J. Electrochem. Soc., Vol. 155, No. 11, pages D693 - D698 disclose electrochemical atomic layer deposition as a technique for electrodeposition of nanofilms, which has been used extensively to form a variety of compound semiconductors, and more recently, metals. The basic approach toward deposition of materials via electrochemical ALD is to first identify the underpotentials needed for the constitue and elements, using cyclic voltametry, and then to create an EC-ALD cycle. Sb₂Te₃ is an important compound in the family of PCM materials, and other important PCM materials are Sb₂Te₃ doped with elements such as Ge, Ga, Ag, In, etc.

Lee et al., "Highly scalable non-volatile and ultra-low-power phase-change nanowire memory", nature nanotechnology, Vol. 2, pages 626 - 630, October 2007, describe Ge-Sb-Te nanowires which are synthesized by a vapour-liquid-solid (VLS) process. According to that Ge₂Sb₂Te₅ nanowires are synthesized using a metal catalyst-mediated vapour-liquid-solid process, using GeTe and Sb₂Te₃ powders as precursors, wherein the powders are separately located inside a horizontal tube furnace in different temperate zones in order to simultaneously produce vapour-phased reactants. A Si substrate covered with Au nanoclusters is placed at the downstream side of the furnace.

### Summary of the Invention

It is an object of the present invention to provide an improved method for fabricating Ge-Sb-Te nanowires. Another object of the present invention is to provide an improved method for fabricating multi-component nanowires which makes the fabrication process easier and offers low fabrication cost by enabling it to fabricate multi-component nanowires in a nanotemplate having a plurality of pores by an electroplating process with the use of a multi-component solution.

According to the present invention, there is provided a method for fabricating Ge-Sb-Te nanowires comprising the steps of: (a) preparing an anodized aluminum oxide nanotemplate having a plurality of pores, (b) forming an electrode layer on one surface of the anodized aluminum oxide nanotemplate, (c) injecting the anodized aluminum oxide nanotemplate in a Ge-Sb-Te solution and then growing Ge-Sb-Te nanowires through the pores of the anodized aluminum oxide nanotemplate by an electroplating process in which the anodized aluminum oxide nanotemplate is used as a cathode, and (d) removing the anodized aluminum oxide nanotemplate.

The diameter of the pores can be several tens to several hundreds of nanometers.

The electrode layer can comprise gold (Au).

The Ge-Sb-Te solution can include GeO₂, SbO₂, and TeO₂ as precursors and hydrochloric acid and ethylglycerol as solvents.

In the step (c), a platinum electrode can be used as an anode.

Further, in the step (c), a composition ratio of the Ge-Sb-Te nanowires can be determined depending on the change of at least one of a mixing ratio of precursors in the Ge-Sb-Te solution and a current density applied during the electroplating process.

In the step (d), the anodized aluminum oxide nanotemplate can be removed with a NaOH solution.

### Brief description of the Drawings

The above and other objects and features of the present invention will become apparent from the following description of preferred embodiments, given in conjunction with the accompanying drawings.

As far as in the following description reference is made to the fabrication of Ag-Se nanowires, the same is not falling within the scope of the invention.

In the drawings:
Figs. 1 to 4 are views showing the configuration of a method for fabricating multi-component nanowires in accordance with one embodiment of the present invention;
Fig. 5 is a photograph of Ag-Se nanowires taken by scanning electron microscopy;
Fig. 6 is a photograph of Ag-Se nanowires taken by transmission electron microscopy;
Fig. 7 is a graph showing the results of analysis of Ag-Se nanowires obtained by energy dispersive X-ray spectroscopy;
Fig. 8 is a photograph of Ag-Se thin film taken by a scanning electron microscopy;
Fig. 9 is a graph showing the results of X-ray diffraction analysis of Ag-Se nanowires;
Fig. 10 is a photograph of Ge-Sb-Te nanowires taken by scanning electron microscopy, which shows the results of analysis of Ge-Sb-Te nanowires obtained by energy dispersive X-ray spectroscopy;
Fig. 11 is a view of Ge-Sb-Te nanowires taken by transmission electron microscopy;
Fig. 12 is a graph showing current changes (I-V) of Ag-Se nanowires; and
Fig. 13 is a graph showing current changes (I-V) of Ag-Se thin film.

### Detailed Description of the Preferred Embodiment

In the following detailed description, reference is made to the accompanying drawings that show, by way of illustration, specific embodiments in which the invention may be practiced. These embodiments are described in sufficient detail to enable those skilled in the art to practice the invention. It is to be understood that the various embodiments of the invention, although different from one another, are not necessarily mutually exclusive. For example, a particular feature, structure, or characteristic described herein in connection with one embodiment may be implemented within other embodiments without departing from the scope of the present invention. Also, it should be understood that the positions or arrangements of individual elements in the embodiment may be changed without separating the scope of the present invention. The following detailed description is, therefore, not to be taken in a limiting sense, and the scope of the present invention is defined only by the appended claims that should be appropriately interpreted along with the full range of equivalents to which the claims are entitled. In the drawings, like reference numerals denote like or similar elements or functions through the several views.

Hereinafter, the configuration of the present invention will be described in detail with reference to the accompanying drawings.

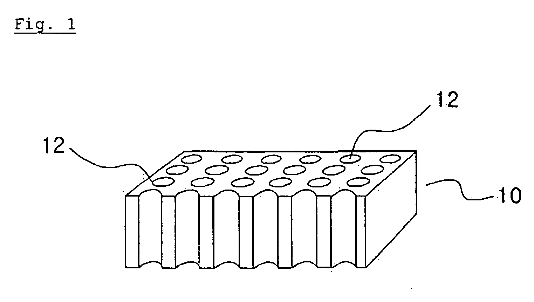

Figs. 1 to 4 show the configuration of a method for fabricating multi-component nanowires in accordance with one embodiment of the present invention.

First of all, referring to Fig. 1, an anodized aluminum oxide nanotemplate 10 is prepared.

The anodized aluminum oxide nanotemplate 10 having a plurality of pores 12 formed thereon can be fabricated as follows.

First, an aluminum having a purity of 99.999% is electrochemically etched to planarize a surface thereof, and then the aluminum is anodized in oxalic acid at a voltage of 40 V and a temperature of 4°C.

When the anodization is carried out once, the uniformity of the pores 12 is poor, and therefore it is preferable to carry out the anodization twice in order to improve the uniformity of the pores 12. To this end, a firstly-formed anodized aluminum oxide layer is removed with chromic acid at a temperature of 65°C. The second anodization is carried out under the same condition as the first anodization.

Next, the aluminum is removed with a silver nitrate aqueous solution in order to leave only an anodized aluminum oxide layer formed by carrying out anodization twice.

Lastly, the pores 12 are expanded by using a phosphoric acid aqueous solution, thereby improving the uniformity of the pores 12 of the anodized aluminum oxide nanotemplate 10. Thus, finally, the preparation of the anodized aluminum oxide nanotemplate 10 having the plurality of the pores 12 is completed (see Fig. 1).

In the above procedure, the diameter of the pores 12 formed on the anodized aluminum oxide nanotemplate 10 is preferably several tens to several hundreds nanometers (nm).

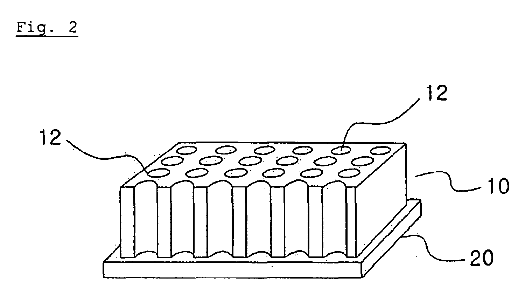

Next, referring to Fig. 2, an electrode layer 20 is formed on one surface of the anodized aluminum oxide nanotemplate 10.

Preferably, the electrode layer 20 is formed at a thickness of 300 to 400 nm by E-beam evaporation process on one surface of the anodized aluminum oxide nanotemplate 10 after completion of the formation of the anodized aluminum oxide nanotemplate 10. Here, the material of the electrode layer 20 may comprise gold (Au).

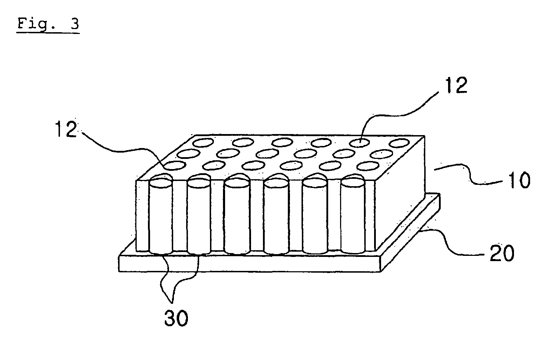

Next, referring to Fig. 3, multi-component nanowires 30 are grown through the pores 12 of the anodized aluminum oxide nanotemplate 10 by using an electroplating process.

That is, the anodized aluminum oxide nanotemplate 10 having the plurality of pores 12 is injected in a multi-component solution, and then the electroplating process is carried out by using the anodized aluminum oxide nanotemplate 10 as a cathode.

The multi-component solution used at this time may be an Ag-Se for growing Ag-Se nanowires or Ge-Sb-Te solution for growing Ge-Sb-Te nanowires according to the invention that constitute the memory layer of the PRAM.

In the electroplating, a platinum electrode may be used as an opposite electrode of the anodized aluminum oxide nanotemplate 10 which is used as the cathode, i.e., an anode. Here, the purity of the platinum is preferably 99.99%.

If the multi-component solution is Ag-Se solution, the precursors may include Ag and Se and the solvents may include nitric acid and ethylglycerol. In case of producing a total of 500 mℓ of Ag-Se solution, 0.1 mol of Ag, 0.05 mol of Se, 10 mℓ of nitric acid, and 100 mℓ of ethylglycerol were used.

According to the present invention, the multi-component solution is Ge-Sb-Te solution, and the precursors may include GeO₂, SbO₂, and TeO₂ and the solvents may include hydrochloric acid and ethylglycerol. In this embodiment, in case of producing a total of 500 mℓ of Ge-Sb-Te solution, 0.0428 mol of GeO₂, 0.0028 mol of SbO₂ 0.007 mol of TeO₂ 10 mℓ of hydrochloric acid, and 100 mℓ of ethylglycerol were used.

In the electroplating process of growing multi-component nanowires, a composition ratio of the multi-component nanowires can be determined depending on the change of at least one of a mixing ratio of the precursors in a multi-component solution and an applied current density.

In this case, if the multi-component solution is Ag-Se solution, the current density is preferably 2 mA/cm², and if the multi-component solution is Ge-Sb-Te solution as according to the invention, the current density is preferably 1 mA/cm².

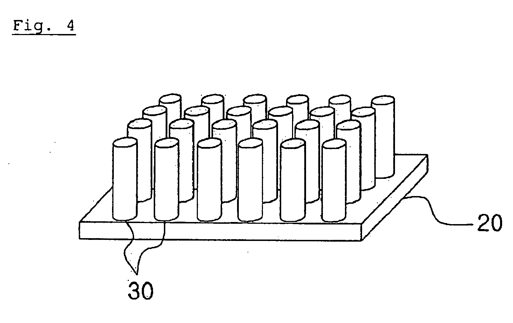

Lastly, referring to Fig. 4, the anodized aluminum oxide nanotemplate 10 is removed, thereby finally obtaining multi-component nanowires 30. At this time, the anodized aluminum oxide nanotemplate 10 is preferably removed with NaOH (sodium hydroxide) solution. Afterwards, it is preferred that the multi-component nanowires 30 are washed with ultrapure water and ethanol.

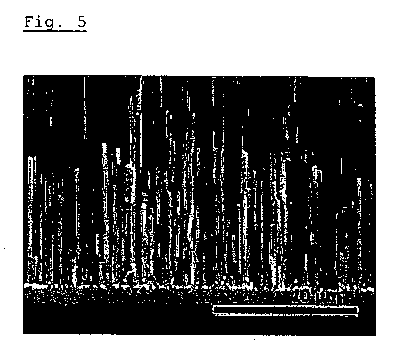

Fig. 5 is a photograph of Ag-Se nanowires taken by scanning electron microscopy (SEM). It can be seen that Ag-Se nanowires are grown uniformly in the anodized aluminum oxide nanotemplate.

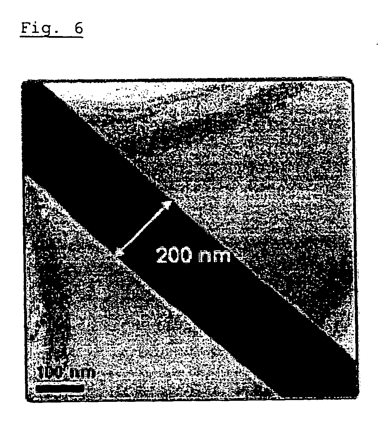

Fig. 6 is a photograph of Ag-Se nanowires taken by transmission electron microscopy (TEM). It can also be seen that Ag-Se nanowires are grown uniformly in the anodized aluminum oxide nanotemplate.

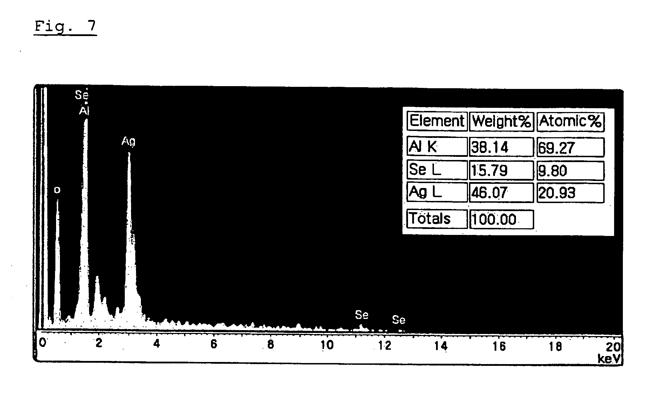

Fig. 7 is a graph showing the results of analysis of Ag-Se nanowires obtained by energy dispersive X-ray spectroscopy (EDS). It can be seen that the composition ratio of Ag and Se constituting Ag-Se nanowires is 2:1, which is the same as the mixing ratio of the precursors (that is, Ag and Se) in the multi-component (Ag-Se) solution.

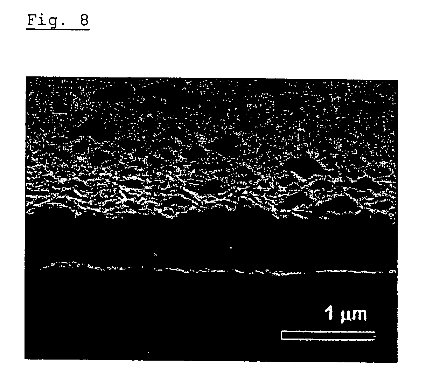

Figs. 8-9 show the properties of Ag-Se thin film formed on a silicon wafer by an electroplating process under the same environment as the multi-component (Ag-Se) solution in which Ag-Se nanowires are grown, which is a comparative example of Figs. 5-7. To this end, gold (Au) is deposited at a thickness of 300∼400 nm on the silicon wafer by E-beam evaporation process, and then Ag-Se thin film is formed thereon.

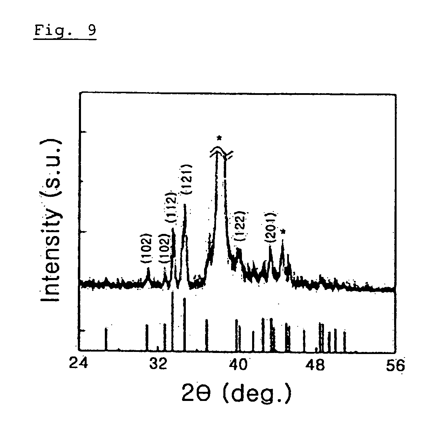

Fig. 8 is a photograph of Ag-Se nanowires taken by scanning electron microscopy, and Fig. 9 is a graph showing the results of X-ray diffraction analysis of Ag-Se thin film.

In Fig. 9, the upper peak represents an X-ray diffraction peak of Ag-Se thin film grown by the electroplating process in this embodiment, and the lower peak represents an X-ray diffraction peak of a typical silver selenide (Ag₂Se). As shown therein, considering that the upper and lower peaks match each other, it can be seen that the composition ratio of Ag-Se nanowires grown by electroplating in this embodiment is 2:1, which is the mixing ratio of Ag and Se serving as the precursors in the multi-component (Ag-Se) solution. In view of this, according to the method for fabricating multi-component nanowires of the present invention, the composition ratio of final multi-component nanowires can be controlled based on the mixing ratio of the precursors in the multi-component solution.

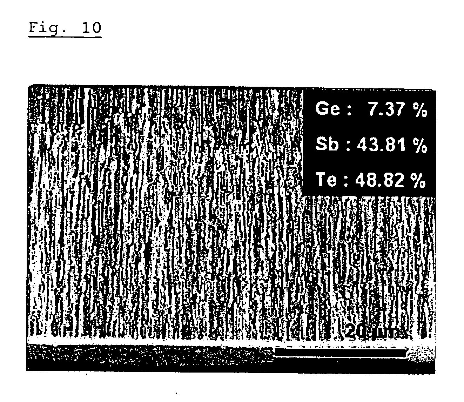

Fig. 10 is a photograph of Ge-Sb-Te nanowires taken by scanning electron microscopy, which also shows the results of analysis of GST nanowires obtained by energy dispersive X-ray spectroscopy (EDS). It can be seen that Ge-Sb-Te nanowires are grown uniformly in an anodized aluminum oxide nanotemplate and the composition of the Ge-Sb-Te nanowires is 1:6:6.5. From this, according to the method for fabricating multi-component nanowires of the present invention, even if there are three or more types of precursors in a multi-component solution, multi-component nanowires containing all of these precursors can be fabricated.

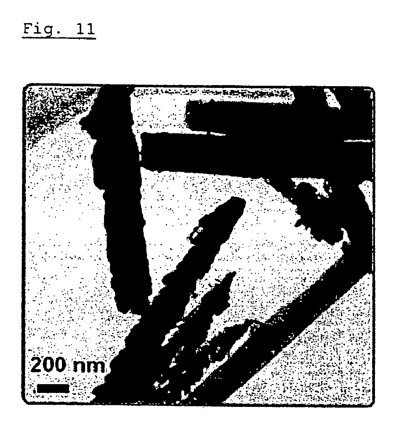

Fig. 11 is a view of Ge-Sb-Te nanowires taken by transmission electron microscopy. Also, it can be found that Ge-Sb-Te nanowires are grown uniformly in an anodized aluminum oxide nanotemplate.

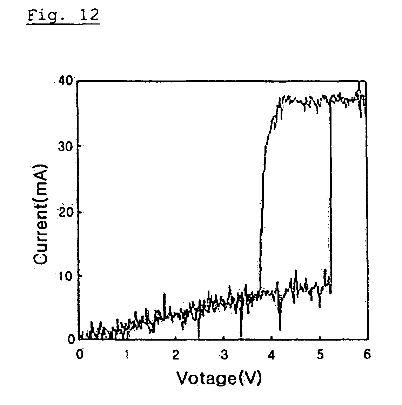

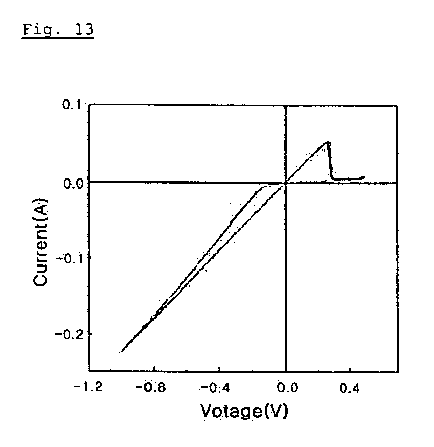

Figs. 12 and 13 are graphs showing current changes (I-V) of Ag-Se nanowires and Ag-Se thin film, which are the results measured by using conductive atomic force microscopy (C-AFM) and 4-probe station, respectively.

As shown therein, both Ag-Se nanowires and Ag-Se thin film undergo an abrupt change in resistance at a certain voltage. Hence, this embodiment shows that Ag-Se nanowires grown by the electroplating process are sufficiently applicable to a nanowire-based PRAM device.

As described above, the method for fabricating multi-component nanowires in accordance with the present invention can fabricate multi-component nanowires in a nanotemplate having a plurality of pores by electroplating with the use of a multi-component solution, thereby making the nanowires fabrication process easier and thus offering low fabrication cost.

Although the method for fabricating multi-component nanowires in accordance with the present invention has been described with respect to Ag-Se nanowires and Ge-Sb-Te nanowires that are applicable to PRAM devices, the present invention is not limited thereto but may also be applied to Ag-Se nanowire-based, Ge-Sb-Te nanowire-based ReRAM devices, and In-Se nanowire-based, Te-Se nanowire-based, and In-Ag-Se nanowire-based PRAM and ReRAM devices.

Further, the method for fabricating multi-component nanowires in accordance with the present invention may also be utilized in the fields of nanobiosensors, fuel cells, and biological cell isolation, in addition to the memory devices including PRAM and ReRAM.

While the present invention has been described with respect to certain preferred embodiments, it will be apparent to those skilled in the art that various changes and modifications may be made without departing from the scope of the invention as defined in the following claims.

## Claims

1. A method for fabricating Ge-Sb-Te nanowires (30), comprising the steps of:
(a) preparing an anodized aluminum oxide nanotemplate (10) having a plurality of pores (12);
(b) forming an electrode layer on one surface of the anodized aluminum oxide nanotemplate (10);
(c) injecting the anodized aluminum oxide nanotemplate (10) in a Ge-Sb-Te solution and then growing Ge-Sb-Te nanowires (30) through the pores (12) of the anodized aluminum oxide nanotemplate (10) by an electroplating process in which the anodized aluminum oxide nanotemplate (10) is used as a cathode; and
(d) removing the anodized aluminum oxide nanotemplate (10).

2. The method of claim 1, wherein the diameter of the pores (12) is several tens to several hundreds of nanometers.

3. The method of claim 1, wherein the electrode layer comprises gold (Au).

4. The method of claim 1, wherein the Ge-Sb-Te solution includes GeO₂, SbO₂, and TeO₂ as precursors and hydrochloric acid and ethylglycerol as solvents.

5. The method of claim 1, wherein in said step (c), a platinim electrode is used as an anode.

6. The method of claim 1, wherein in said step (c), a composition ratio of the Ge-Sb-Te nanowires (30) is determined depending on the change of at least one of a mixing ratio of precursors in the Ge-Sb-Te solution and a current density applied during the electroplating process.

7. The method of claim 1, wherein in said step (d), the anodized aluminum oxide nanotemplate (10) is removed with a NaOH solution.

## Patentansprüche

1. Verfahren zum Herstellen von GE-Sb-Te Nanodrähten (30) mit dem Schritten:
(a) Vorbereiten einer anodisierten Aluminiumoxid-Nanoschablone (10), die eine Vielzahl von Poren (12) aufweist;
(b) Ausbilden einer Elektrodenschicht auf einer Oberfläche der anodisierten Aluminiumoxid-Nanoschablone (10);
(c) Beaufschlagen der anodisierten Aluminiumoxid-Nanoschablone (10) mit einer Ge-Sb-Te Lösung und dann Züchten von Ge-Sb-Te Nanodrähten durch die Poren (12) der anodisierten Aluminiumoxid-Nano-Schablone (10) mittels eines Elektroplattierungsprozesses, bei dem die anodisierte Aluminiumoxid-Nanoschablone (10) als Kathode vermendet wird; und
(d) Entfernen der anodisierten Aluminiumoxid-Nanoschablone (10).

2. Verfahren nach Anspruch 1, bei dem der Durchmesser der Poren (12) einige zehn bis mehrere hundert Nanometer ist.

3. Verfahren nach Anspruch 1, bei dem die Elektrodenschicht Gold (Au) umfasst.

4. Verfahren nach Anspruch 1, bei dem die Ge-Sb-Te Lösung GeO₂, SbO₂ und TeO₂ als Ausgangsstoffe und Salzsäure und Ethylglycerol als Lösungsmittel enthält.

5. Verfahren nach Anspruch 1, bei dem in Schritt (c) eine Platinelektrode als Anode verwendet wird.

6. Verfahren nach Anspruch 1, bei dem in Schritt (c) das Zusammensetzungsverhältnis von den Ge-Sb-Te Nanodrähten (30) in Abhängigkeit der Änderung von mindestens einem vom Mischungsverhältnis der Ausgangsstoffe in der Ge-Sb-Te Lösung und der während des Elektroplattierungsprozesses angelegten Stromdichte festgelegt wird.

7. Verfahren nach Anspruch 1, bei dem in Schritt (d) die anodisierte Aluminiumoxid-Nanoschablone (10) mittels einer NaOH-Lösung entfernt wird.

## Revendications

1. Procédé de fabrication de nanofils de Ge-Sb-Te (30), comprenant les étapes de :
(a) préparation d'une nanomatrice d'oxyde d'aluminium anodisé (10) comprenant une pluralité de pores (12) ;
(b) formation d'une couche d'électrode sur une surface de la nanomatrice d'oxyde d'aluminium anodisé (10) ;
(c) injection de la nanomatrice d'oxyde d'aluminium anodisé (10) dans une solution de Ge-Sb-Te, puis croissance de nanofils de Ge-Sb-Te (30) à travers les pores (12) de la nanomatrice d'oxyde d'aluminium anodisé (10) par un procédé d'électroplaquage dans lequel la nanomatrice d'oxyde d'aluminium anodisé (10) est utilisée en tant que cathode ; et
(d) retrait de la nanomatrice d'oxyde d'aluminium anodisé (10).

2. Procédé selon la revendication 1, dans lequel le diamètre des pores (12) est de plusieurs dizaines à plusieurs centaines de nanomètres.

3. Procédé selon la revendication 1, dans lequel la couche d'électrode comprend de l'or (Au).

4. Procédé selon la revendication 1, dans lequel la solution de Ge-Sb-Te comprend GeO₂, SbO₂ et TeO₂ en tant que précurseurs et de l'acide chlorhydrique et de l'éthylglycérol en tant que solvants.

5. Procédé selon la revendication 1, dans lequel dans ladite étape (c), une électrode de platine est utilisée en tant qu'anode.

6. Procédé selon la revendication 1, dans lequel, dans l'étape (c), un rapport de composition des nanofils de Ge-Sb-Te (30) est déterminé en fonction du changement d'au moins un d'un rapport de mélange de précurseurs dans la solution de Ge-Sb-Te et d'une densité de courant appliquée pendant le procédé d'électroplaquage.

7. Procédé selon la revendication 1, dans lequel, dans ladite étape (d), la nanomatrice d'oxyde d'aluminium anodisé (10) est retirée avec une solution de NaOH.
